# EUROPÄISCHE PATENTSCHRIFT

(11) **EP 1 245 050 B1**
(45) Veröffentlichungstag und Bekanntmachung des Hinweises auf die Patenterteilung: **26.03.2008**
(21) Anmeldenummer: 00958384.0
(22) Anmeldetag: 04.08.2000
(51) Int. Cl.: H01L 29/78, H01L 29/08, H01L 21/336

(54) **STEUERBARES IN BEIDE RICHTUNGEN SPERRENDES HALBLEITERSCHALTELEMENT**
CONTROLLABLE SEMICONDUCTOR SWITCHING ELEMENT WITH BIDIRECTIONAL BLOCKING CAPABILITY
ELEMENT DE COMMUTATION A SEMI-CONDUCTEUR COMMANDABLE A BLOCAGE BIDIRECTIONNEL

(30) Priorität: 06.12.1999 DE 19958694
(43) Veröffentlichungstag der Anmeldung: 02.10.2002
(73) Patentinhaber: Infineon Technologies AG, 81669 München (DE)
(72) Erfinder: TIHANYI, Jenö, D-85551 Kirchheim (DE)
(74) Vertreter: Bickel, Michael
(86) Internationale Anmeldenummer: PCT/EP2000/007603
(87) Internationale Veröffentlichungsnummer: WO 2001/043200

(56) Entgegenhaltungen:
- EP-A- 0 323 549
- WO-A-99/17373
- FR-A- 2 526 587
- PATENT ABSTRACTS OF JAPAN vol. 012, no. 449 (E-686), 25. November 1988 (1988-11-25) & JP 63 177473 A (NISSAN MOTOR CO LTD), 21. Juli 1988 (1988-07-21)

## Beschreibung

Die vorliegende Erfindung betrifft ein steuerbares Halbleiterschaltelement, insbesondere ein durch Feldeffekt steuerbares Halbleiterschaltelement, das folgende Merkmale aufweist:
- eine erste Leitungszone und eine zweite Leitungszone eines ersten Leitungstyps;
- eine zwischen der ersten und zweiten Leitungszone angeordnete Kanalzone eines zweiten Leitungstyps;
- eine isoliert gegenüber der Kanalzone angeordnete Steuerelektrode.

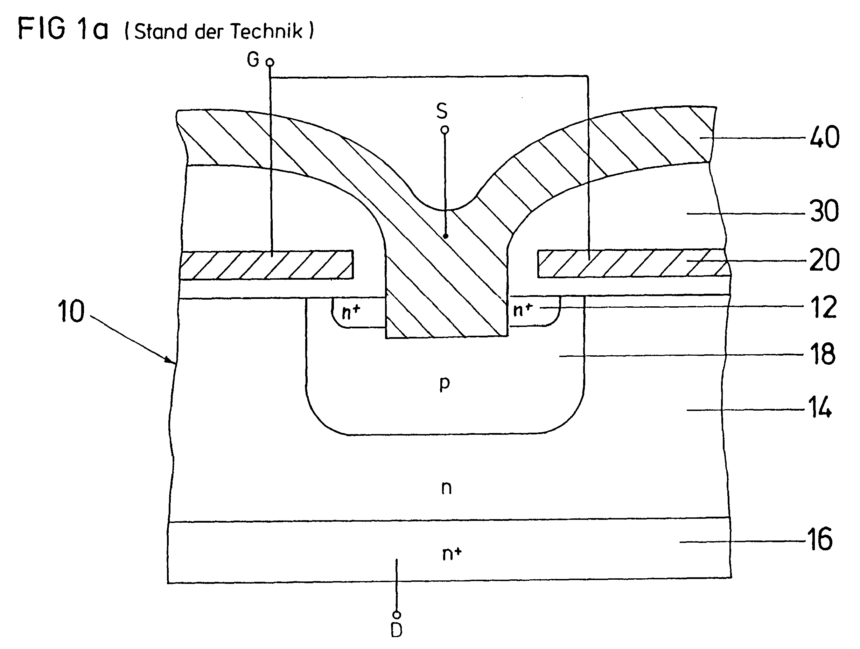

Derartige Halbleiterschaltelemente sind beispielsweise nach dem Stand der Technik bekannte MOSFET (Metal Oxide Field Effect Transistor). Eine Ausführungsform eines vertikalen Leistungs-MOSFET nach dem Stand der Technik ist in Stengl/Tihanyi: "Leistungs-MOSFET-Praxis", Pflaum Verlag, München, 1992, Seite 29ff., beschrieben und ist in Figur 1a ausschnittsweise im Querschnitt dargestellt. Der MOSFET weist eine Source-Zone als erste Leitungszone 12 eines ersten Leitungstyps (n) auf, die in eine wannenartige Kanalzone (auch Body-Zone oder Sperrzone genannt) eines zweiten Leitungstyps (p) eingebracht ist. Die Source-Zone 12 ist über eine Source-Elektrode 40 von außen kontaktierbar, wobei die Source-Elektrode 40 durch die Source-Zone 12 bis in die Kanalzone reicht und damit die Source-Zone 12 und die Kanalzone 18 kurzschließt.

Die Kanalzone 18 ist in eine zweite Leitungszone 14, 16 des ersten Leitungstyps (n) -die Drain-Zone des MOSFET - eingebracht, wobei die zweite Leitungszone eine n-dotierte, die Kanalzone 18 umgebende Zone 14 und eine stärker n-dotierte Zone 16 zum Anschließen einer Drain-Elektrode aufweist. Isoliert gegenüber der Kanalzone 18 und den Source- und Drain-Zonen 12, 14 ist eine Gate-Elektrode als Steuerelektrode 20 des MOSFET oberhalb eines Halbleiterkörpers, in dem die Source-Zone 12, die auch als Vorwärtsrichtung bezeichnet ist, und die Drain-Zone ausgebildet ist, die auch als Rückwärtsrichtung bezeichnet ist, angeordnet.

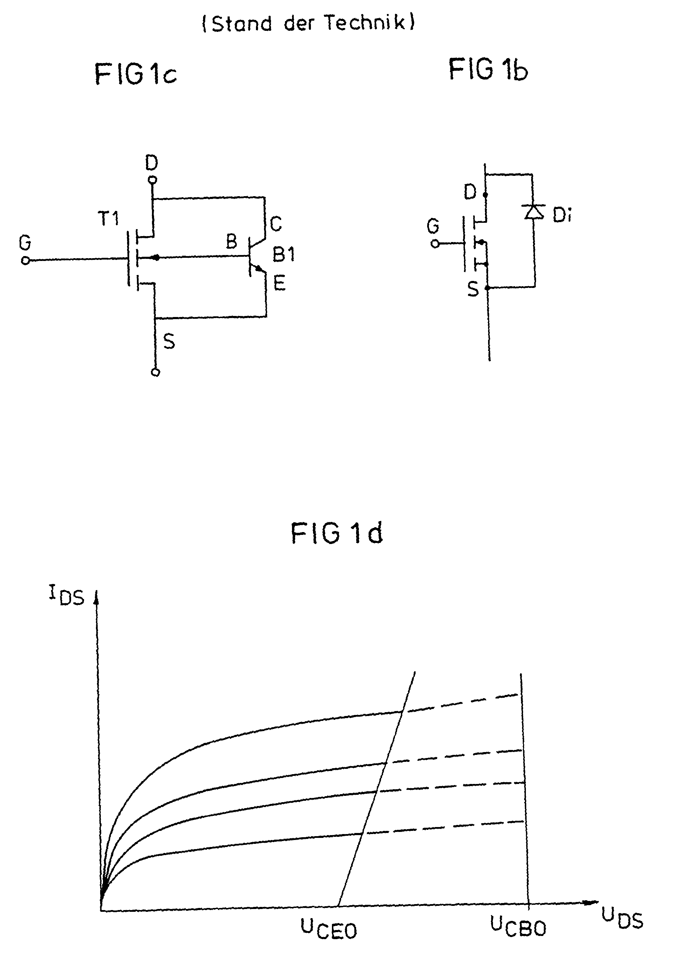

Ein Ersatzschaltbild des Vertikal-MOSFET nach Figur 1a ist in Figur 1b dargestellt, das sich als eine Kombination aus einem idealen MOSFET T1 und einer Diode Di darstellt, wobei die Diode in Flussrichtung zwischen den Source-Anschluss S und den Drain-Anschluss D des MOSFET geschaltet ist. Die Diode, die bei Anlegen einer positiven Spannung in Source-Drain-Richtung leitet resultiert aus dem pn-Übergang zwischen der Drain-Zone 14, 16 und der Body-Zone 18 und dem Kurzschluss zwischen der Body-Zone 18 und der Source-Zone 12.

Das Vorhandensein der integrierten Diode ist für einige Anwendungen des MOSFET nachteilig, da sie bewirkt dass der MOSFET nur noch bei Anlegen einer Flussspannung in Drain-Source-Richtung leitet, während er bei Anlegen einer Spannung in Source-Drain-Richtung wie eine Diode leitet.

Ohne den Kurzschluss zwischen der Source-Zone und der Body-Zone wäre in dem MOSFET ein parasitärer Bipolartransistor wirksam, der durch die Abfolge der unterschiedlich dotierten Zonen, nämlich der Source-Zone des ersten Leitungstyps, der Kanalzone des zweiten zu dem ersten Leitungstyp komplementären Leitungstyps und der Drain-Zone des ersten Leitungstyps, ausgebildet ist, wobei dessen Basis durch die Kanalzone und wobei dessen Emitter/Kollektor durch die Source-Zone/Drain-Zone gebildet werden.

Figur 1c zeigt das elektrische Ersatzschaltbild eines MOSFET ohne Kurzschluss zwischen Source-Zone und Drain-Zone, das sich als Kombination eines idealen MOSFET T1 mit einem Bipolartransistor darstellt. Die Kollektor-Emitter-Strecke C-E des Bipolartransistors B1 ist parallel zur Drain-Source-Strecke D-S des MOSFET T1 geschaltet. Die Basis-Zone des parasitären Bipolartransistors B1 wird durch die Kanalzone des MOSFET, die Emitter-Zone durch die Source-Zone des MOSFET und die Kollektor-Zone durch die Drain-Zone des MOSFET gebildet.

Der parasitäre Bipolartransistor B1 beeinflusst die Spannungsfestigkeit des Halbleiterschaltelements gemäß Figur 1c, wie das Kennlinienfeld dieses Halbleiterschaltelements in Figur 1d zeigt. Bei einer Drain-Source-Spannung U_{DS} vom Wert U_{CEO}, ist die Kollektor-Emitter-Durchbruchspannung des parasitären Bipolartransistors B1 und damit die maximale Sperrspannung des Halbleiterschaltelements in Drain-Source-Richtung D-S erreicht. Mit zunehmender Gate-Source-Spannung steigt die Spannungsfestigkeit leicht an, wie dem Kennlinienfeld zu entnehmen ist. Bis zum Erreichen dieser Durchbruchspannung entspricht das Verhalten des Halbleiterschaltelements dem eines idealen MOSFET.

Die Reduktion der Spannungsfestigkeit bei einem MOSFET mit nicht kurzgeschlossener Source-Zone und Sperrzone resultiert daraus, dass sich während des Betriebs, das heißt bei Anlegen eines Ansteuerpotentials an den Gate-Anschluss und bei Anlegen einer Flussspannung zwischen Drain und Source, Ladungsträger in dem Substrat ansammeln. Diese Ladungsträger steuern die Basis des parasitären Bipolartransistors an, wodurch dieser leitend wird. Die Spannungsfestigkeit eines derartigen MOSFET in Drain-Source-Richtung beträgt etwa nur noch 1/3 der Spannungsfestigkeit eines vergleichbaren Bauelements mit kurzgeschlossener Source- und Body-Zone.

Ziel der vorliegenden Erfindung ist es, ein steuerbares Halbleiterschaltelement zur Verfügung zu stellen, welches in beiden Richtungen sperrt ohne dass die Sperrspannung in einer Haupt-Spannungsrichtung (Vorwärtsrichtung) reduziert ist. Ein in beide Richtungen sperrendes steuerbares Halbteiterschaltelement ist z.B. aus der FR-A-2 526 587 bekannt.

Diese Aufgabe wird durch ein Halbleiterschaltelement gemäß Anspruch 1 gelöst. Das erfindungsgemäß Halbteiterschaltelement weist wenigstens einen in der Sperrzone ausgebildeten Rekombinationsbereich aus einem eine Rekombination von Ladungsträgern des ersten und zweiten Leitungstyps fördernden Materials auf. Bei dem erfindungsgemäßen Halbleiterschaltelement ist kein Kurzschluss zwischen der Kanalzone und einer der beiden Leitungszonen vorgesehen, so daß es in beide Richtungen sperrt.

Durch die Abfolge der nebeneinander angeordneten ersten Leitungszone des ersten Leitungstyps, der Kanalzone des zweiten Leitungstyps und der zweiten Leitungszone des zweiten Leitungstyps, ist in dem erfindungsgemäßen Halbleiterschaltelement ein parasitärer Bipolartransistor gebildet. Das Vorsehen des Rekombinationsbereichs in der Kanalzone des Halbleiterschaltelements, bzw. in der Basiszone des parasitären Bipolartransistors, verändert jedoch das elektrische Verhalten des parasitären Bipolartransistors. Bei Anlegen einer Flussspannung zwischen der ersten und zweiten Leitungszone werden in der Raumladungszone zwischen einer der beiden Leitungszonen und der Kanalzone, Ladungsträger des ersten und zweiten Leistungstyps, nämlich Löcher und Elektronen, generiert. Ladungsträger des ersten Leitungstyps können an der Grenze zum Rekombinationsbereichs, bzw. an dessen Oberfläche, leicht mit Ladungsträgern des zweiten Leitungstyps rekombinieren. Durch die Rekombinationszone wird so erreicht, dass der parasitäre Bipolartransistor nur in sehr geringem Maße angesteuert wird, bzw. es wird erreicht, dass der parasitäre Bipolartransistor bei Vorhandensein einer ausreichend großen Rekombinationszone nicht mehr aktiv wird.

Die Spannungsfestigkeit des erfindungsgemäßen Halbleiterschaltelement entspricht in einer Richtung (Vorwärtsrichtung) damit der Spannungsfestigkeit eines herkömmlichen derartigen Halbleiterschaltelements mit Kurzschluss zwischen einer der Leitungszonen und der Kanalzone. Gleichzeitig sperrt das erfindungsgemäße Halbleiterschaltelement auch bei Anlegen einer Flussspannung in der anderen Richtung (Rückwärtsrichtung), da kein Kurzschluss zwischen einer der Leitungszonen und der Kanalzone vorhanden ist.

Ein entsprechendes Herstellungsverfahren ist im unabhängigen Anspruch 12 beschrieben.

Vorteilhafte Ausgestaltungen der Erfindung sind Gegenstand der Unteransprüche.

Das Material des Rekombinationsbereichs ist vorzugsweise ein Metall. Gemäß weiterer Ausführungsformen ist vorgesehen, den Rekombinationsbereich aus Polysilizium, oder einem anderen Halbleitermaterial, oder aus Silizid, oder einer anderen entsprechenden Halbleiterverbindung, auszubilden.

Das erfindungsgemäße Halbleiterschaltelement ist vorzugsweise zellenartig aufgebaut, das heißt, es sind eine Vielzahl gleichartig aufgebauter und angesteuerter Zellen vorhanden, die jeweils eine erste Leitungszone, eine Kanalzone und eine zweite Leitungszone aufweisen. Jede Zelle weist dabei einen Rekombinationsbereich auf.

Es können mehrere, insbesondere streifenförmig ausgebildete Rekombinationsbereiche beabstandet zueinander in der Kanalzone ausgebildet sein.

Gemäß der Erfindung ist vorgesehen, dass die erste Leitungszone eine stark dotierte Anschlusszone zum Anschließen einer ersten Anschlusselektrode und eine schwächer dotierte Übergangszone zwischen der Anschlusszone und der Kanalzone aufweist, und dass die zweite Leitungszone eine stark dotierte zweite Anschlusszone zum Anschließen einer zweiten Elektrode und eine zwischen der zweiten Anschlusszone und der Kanalzone angeordnete zwei schwächer dotierte zweite Übergangszone aufweist. Die Spannungsfestigkeit des erfindungsgemäßen Halbleiterschaltelements wird wesentlich bestimmt durch die Dotierung der Übergangszonen und den durch die Übergangszonen bestimmten Abstand der Anschlusszonen von der Kanalzone. Bei dieser Ausführungsform, bei welcher jede Leitungszone eine schwächer dotierte Übergangszone aufweist, kann durch die Dicke und die Dotierung der Übergangszonen eine in Vorwärtsrichtung und in Rückwärtsrichtung etwa gleiche Spannungsfestigkeit des Halbleiterschaltelements eingestellt werden.

Die vorliegende Erfindung wird nachfolgend in Ausführungsbeispielen anhand von Figuren näher erläutert. In den Figuren zeigt:
- Figur 1:: MOSFET nach dem Stand der Technik im Querschnitt (Fig. 1a) und dessen Ersatzschaltbild (Fig. 1b), Ersatzschaltbild (Fig. 1c) und Kennlinienfeld (Fig. 1d) eines MOSFET ohne Kurzschluss zwischen Source- und Body-Bereich;
- Figur 2:: einen Ausschnitt eines Halbleiterschaltelements im Querschnitt;
- Figur 3:: einen Querschnitt durch das Halbleiterschaltelement gemäß Figur 2 entlang einer Linie a-a';
- Figur 4:: einen Querschnitt durch das Halbleiterschaltelement gemäß Figuren 2 und 3 entlang einer Linie b-b';
- Figur 5:: einen Ausschnitt eines Halbleiterschaltelements im Querschnitt;
- Figur 6:: ein Ersatzschaltbild des Halbleiterschaltelements gemäß Figur 5;
- Figur 7:: einen Ausschnitt eines Halbleiterschaltelements im Querschnitt;
- Figur 8:: einen Querschnitt durch das Halbleiterschaltelement gemäß Figur 7 entlang einer Linie c-c';
- Figur 9:: einen Ausschnitt eines Halbleiterschaltelements im Querschnitt;
- Figur 10:: ein Halbleiterschaltelement in lateraler Ausbildung;
- Figur 11:: Querschnitt durch ein erfindungsgemäßes Halbleiterschaltelement gemäß einer Ausführungsform in Seitenansicht;
- Figur 12:: Querschnitt durch das Halbleiterschaltelement nach Figur 11 im Querschnitt entlang der Schnittebene A-A';
- Figur 13:: Querschnitt durch einen Randbereich des Halbleiterschaltelements nach den Figuren 11 und 12 in Seitenansicht;
- Figur 14:: Querschnitt durch ein Halbleiterschaltelement nach den Figuren 11 und 12 während verschiedener Verfahrensschritte des Herstellungsverfahrens.

In den Figuren bezeichnen, sofern nicht anders angegeben, gleiche Bezugszeichen gleiche Teile und Bereiche mit gleicher Bedeutung.

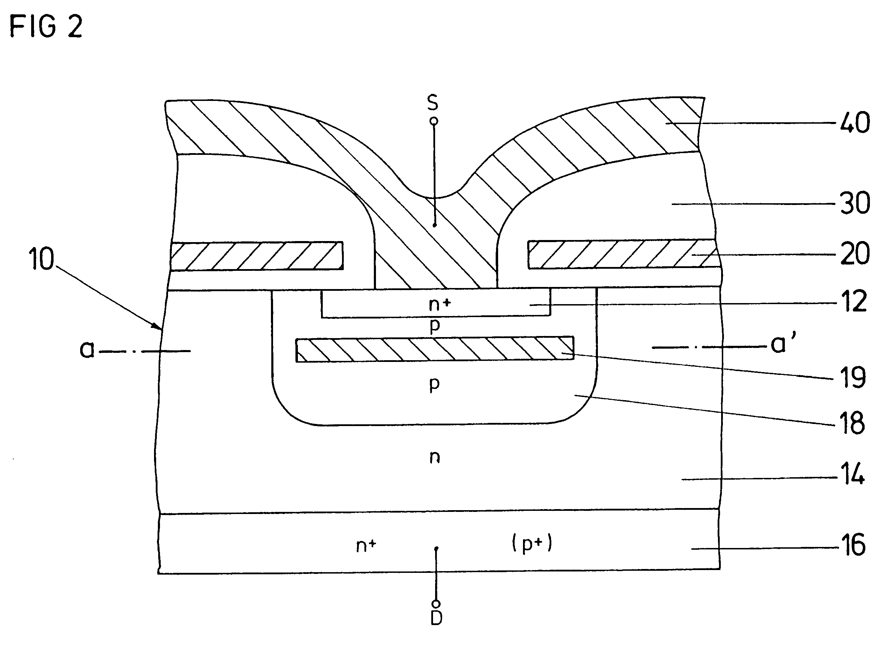

Figur 2 zeigt einen Querschnitt durch einen Ausschnitt eines Halbleiterschaltelements zur Erläuterung der vorliegenden Erfindung Das dargestellte Halbleiterschaltelement besitzt den Aufbau eines vertikalen n-leitenden MOS-Transistors, insbesondere eines n-leitenden MOSFET. In einem n-leitenden Halbleiterkörper 10 ist dabei eine p-leitende Zone als Kanalzone 18, die auch als Body-Zone oder Sperrzone bezeichnet ist, ausgebildet, in die wiederum eine hochdotierte n-leitende Zone 12 eingebracht ist, die als erste Leitungszone, oder Source-Zone, des MOSFET dient. Der Halbleiterkörper 10 weist einen n-leitenden Bereich 14 und im Bereich einer der Source-Zone abgewandten Seite einen hochdotierten n-leitenden Bereich 16 auf, die zusammen die zweite Leitungszone, oder Drain-Zone, bilden. Der stark dotierte Bereich 16 dient zum Anschluss an eine Drain-Elektrode D.

Die Source-Zone 12 ist mit einer Source-Elektrode 40, S, beispielsweise aus Aluminium, verbunden, wobei die Source-Elektrode 40 die Source-Zone an einer Oberfläche des Halbleiterkörpers 10 kontaktiert. Wenigstens eine Gate-Elektrode 20, die als Steuerelektrode des MOSFET dienen, sind über der Sperrzone 12 und von dieser durch eine Isolationsschicht 30 getrennt angeordnet. Die Gate-Elektrode 20 besteht beispielsweise aus Polysilizium, die Isolationsschicht 30 beispielsweise aus einem Siliziumoxid. Die dargestellte Struktur wiederholt sich vorzugsweise nach links und rechts und senkrecht zur Zeichenebene mehrmals, wodurch eine zellenartige Struktur des Halbleiterschaltelements entsteht. Die Stromfestigkeit des Halbleiterschaltelements steigt mit der Anzahl der Zellen.

Der dargestellte MOSFET weist einen parasitären Bipolartransistor auf, wobei dessen Emitter-Zone durch die Source-Zone 12, dessen Basis-Zone durch die Kanalzone 18 und dessen Kollektor-Zone durch die Drain-Zone 14, 16 des Vertikal-MOSFET gebildet wird.

In der Kanalzone 18 des MOSFET, bzw. der Basis-Zone des parasitären Bipolartransistors, ist eine Rekombinationszone 19 aus einem die Rekombination von n-Ladungsträgern und p-Ladungsträgern in dieser Zone fördernden Material angeordnet. Die Rekombinationszone besteht vorzugsweise aus einem Metall, einem Polysilizium oder einem Silizid und ist beispielsweise plattenförmig ausgebildet.

Wird bei dem Halbleiterschaltelement eine positive Spannung zwischen der Drain-Zone 14, 16, bzw. einer auf die Zone 16 aufgebrachten, nicht näher dargestellten Drain-Elektrode, und der Source-Zone 12, bzw. der Source-Elektrode 40, eine positive Spannung angelegt, werden in der Raumladungszone zwischen der Drain-Zone 14 und der Kanalzone 18 Ladungsträger, nämlich Elektronen und Löcher, generiert.

Die Löcher fließen dabei aufgrund des Feldes in der Raumladungszone in die Drain-Zone 14, 16, die Löcher fließen in die Sperrzone. An der Oberfläche des Rekombinationsbereichs 19 findet verstärkt eine Rekombination der injizierten Löcher mit Elektronen statt, wodurch verhindert wird, dass der parasitäre Bipolartransistor aktiv wird und die Sperrspannung in Drain-Source-Richtung reduziert.

Mit anderen Worten: die gute Rekombinationsmöglichkeit von n- und p-Ladungsträgern in der Basis-Zone des parasitären Bipolartransistors senkt dessen Stromverstärkung β und steigert dadurch dessen Kollektor-Emitter-Durchbruchspannung, die die Spannungsfestigkeit des MOSFET über der Drain-Source-Strecke mitbestimmt.

Im Übrigen funktioniert das dargestellte Halbleiterschaltelement wie ein MOSFET, das heißt bei Anlegen eines positiven Ansteuerpotentials an die Gate-Elektrode 20 bildet sich in der Kanalzone zwischen der Source-Zone 12 und der Drain-Zone 14 ein leitender Kanal aus, der bei Anlegen einer Flussspannung zwischen der Drain-Zone 16 und der Source-Elektrode 14 einen Stromfluss zwischen dem Drain-Anschluss D und dem Source-Anschluss S ermöglicht.

Durch geeignete Wahl des Materials und der geometrischen Struktur des Rekombinationsbereichs 19 kann die Durchbruchspannung des MOSFET so weit gesteigert werden, wie sie sich bei einem Kurzschluss zwischen der ersten Leitungszone (Source-Zone) 12 und der Kanalzone 18, d.h. bei kurzgeschlossener Basis-Emitter-Strecke des parasitären Bipolartransistors, ergeben würde, ohne jedoch die nachteilige Wirkung eines solchen Kurzschlusses, nämlich die mangelnde Spannungsfestigkeit in Rückwärtsrichtung (Source-Drain-Richtung), in Kauf nehmen zu müssen. Der dargestellte MOSFET sperrt auch bei Anlegen einer positiven Spannung zwischen der Source-Elektrode 40, bzw. der Source-Zone 12, und der Drain-Zone 14, 16 bedingt durch den pn-Übergang zwischen der Sperrzone 18 und der Source-Zone 12.

Wie in Figur 2 angedeutet ist, kann der Bereich 16 stark p-dotiert anstatt stark n-dotiert sein. Das Halbleiterschaltelement funktioniert dann als IGBT (Insulated Gate Bipolartransistor).

Der Rekombinationsbereich 19 ist vorzugsweise so ausgebildet, dass er eine große Fläche bei geringem Volumenbedarf aufweist.

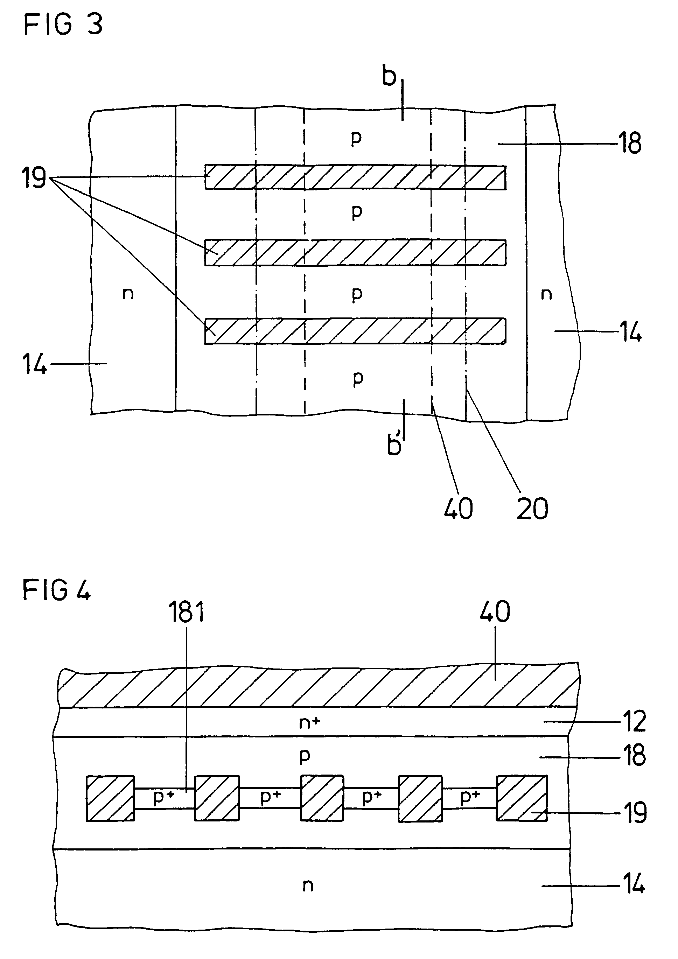

Der Rekombinationsbereich ist daher vorzugsweise plattenförmig, oder, wie in Figur 3 anhand eines Querschnitts entlang der Linie a-a' von Figur 2 dargestellt ist, aus mehreren im wesentlichen parallel verlaufenden streifenförmigen Abschnitten ausgebildet. Die strichpunktierten Linien in Figur 3 veranschaulichen die Lage der darüber liegenden Gate-Elektrode 20. Die gestrichelten Linien veranschaulichen die Lage der darüber liegenden Source-Elektrode 40, S.

Figur 4 zeigt einen Querschnitt durch das Halbleiterschaltelement entlang einer in Figur 3 eingezeichneten Schnittlinie c-c', aus dem die parallele Lage der den Rekombinationsbereich 19 bildenden Streifen deutlich wird. Die einzelnen Unterbereiche des Rekombinationsbereichs 19 sind vorzugsweise durch stark p-dotierte Bereiche 181 miteinander verbunden, um den Ladungsaustausch zwischen den Unterbereichen des Rekombinationsbereichs 19 zu fördern.

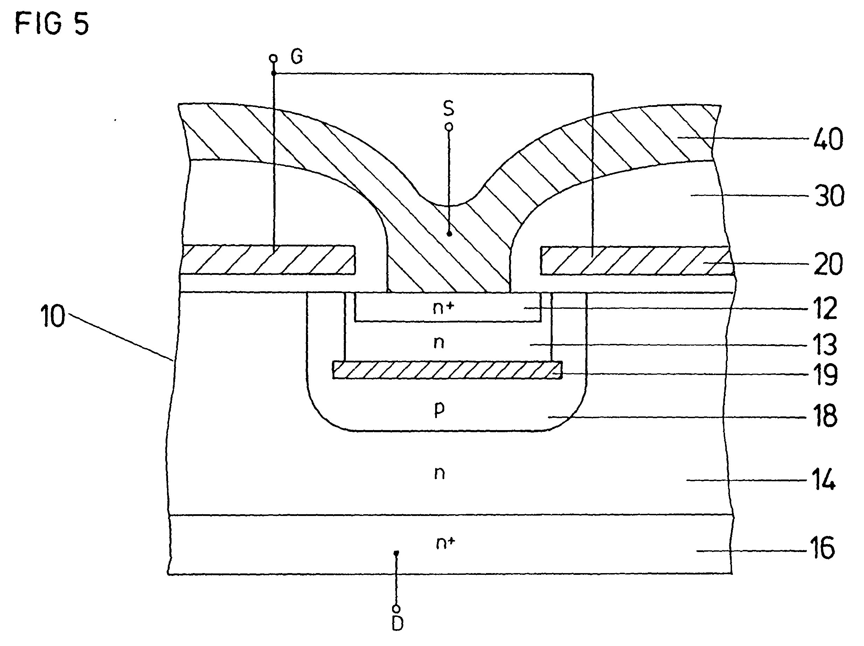

Figur 5 zeigt ein weiteres Halbleiterschaltelement, zur Erlaüterung der vorliegenden Erfindung, wobei der Rekombinationsbereich 19 und die stark n-dotierte Source-Zone 12 durch eine n-leitende Zone 13 miteinander verbunden sind. Das Material, des Rekombinationsbereichs 19 ist bei dieses Halbleiterchaltelement vorzugsweise ein Metall oder ein Silizid.

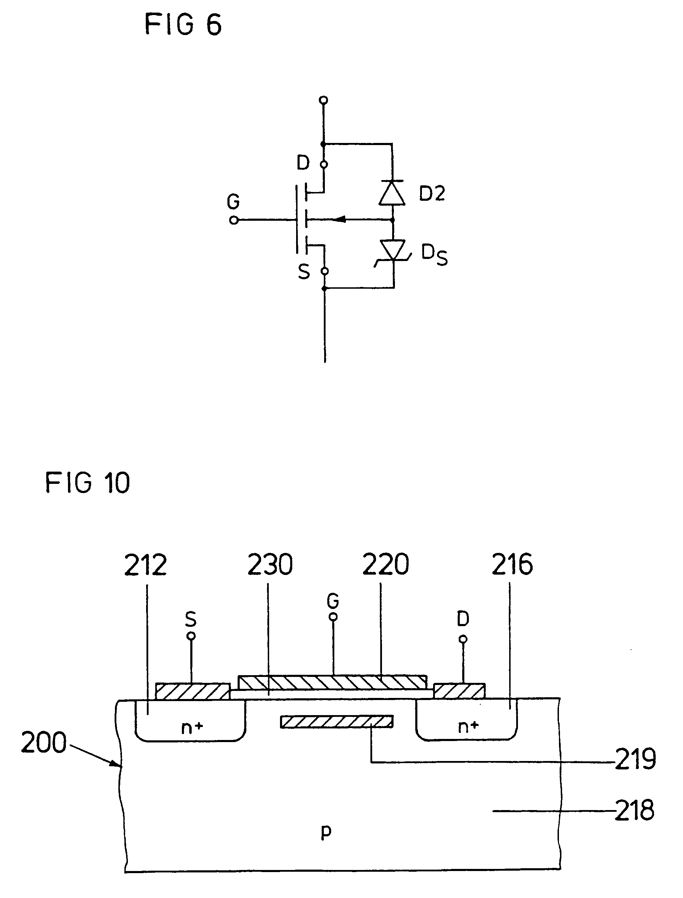

Figur 6 zeigt das Ersatzschaltbild des Halbleiterschaltelements nach Figur 5. Zwischen dem n-leitenden Bereich 13, der Teil der Source-Zone ist, und dem Rekombinationsbereich 19 ist ein Schottky-Übergang gebildet, der als Schottky-Diode Dₛ zwischen dem Source-Anschluss S und dem Substrat-Anschluss des MOSFET eingezeichnet ist. Die Diode D2 zwischen dem Drain-Anschluss D und dem Substrat-Anschluss wird durch den pn-Übergang zwischen der Drain-Zone 14, 16 und der Sperrzone 18 (auch bezeichnet als p-Body-Bereich) gebildet. Die Schottky-Diode Dₛ bestimmt die Sperrspannung des Halbleiterschaltelements in Rückwärtsrichtung (Source-Drain-Richtung), die Diode D2, bzw. der pn-Übergang zwischen der Drain-Zone 14, 16 und der Sperrzone 18 die Spannungsfestigkeit des MOSFET in Vorwärtsrichtung (Drain-Source-Richtung).

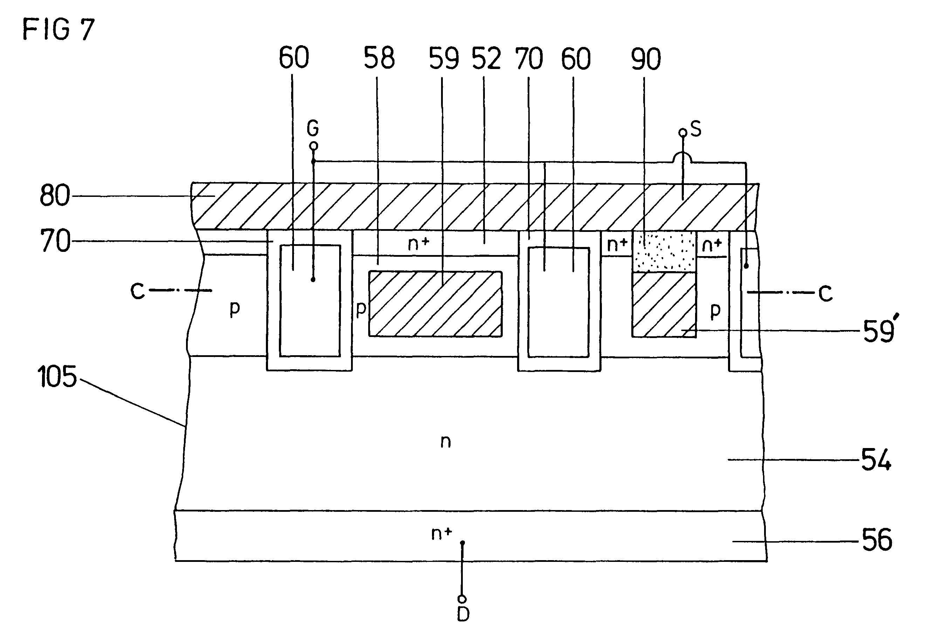

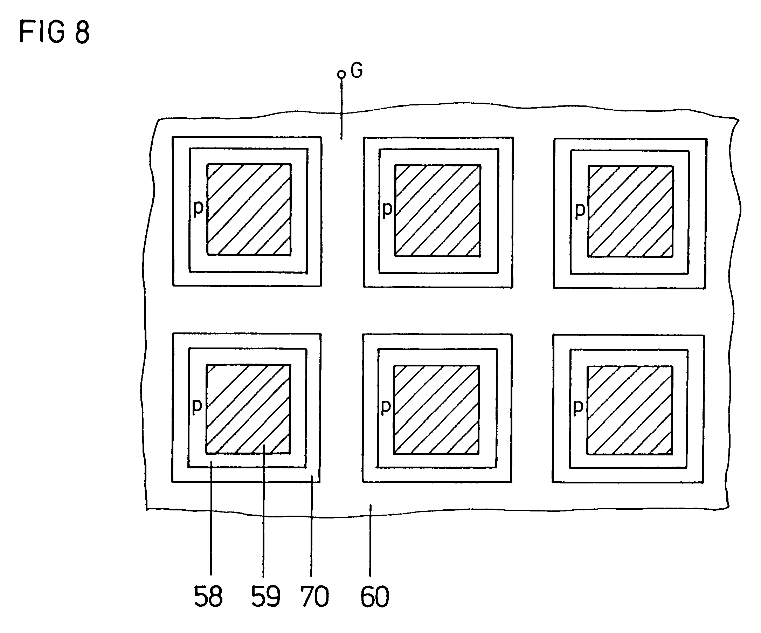

Figur 7 zeigt ausschnittsweise einen Querschnitt durch ein weiteres Halbleiterschaltelement zur Erläuterung der vorliegenden Erfindung. Figur 8 zeigt einen Querschnitt durch dieses Halbleiterschaltelement entlang der in Figur 7 eingezeichneten Schnittlinie c-c'. Eine Gate-Elektrode 60 ist bei diesem Halbleiterschalltelement "vergraben" in einem Halbleiterkörper 105 angeordnet und von einer Isolationsschicht 70 umgeben. Eine Source-Elektrode 80 schließt den Halbleiterkörper 101 nach oben hin ab. Erste stark n-dotierte Leitungszonen (Source-Zonen) 52 sind unterhalb der Source-Elektrode 80 und zwischen der Grabenstruktur der Gate-Elektrode 60 angeordnet. An die Source-Zonen 52 schließen sich p-dotierte Sperrzonen 58 an, in denen Rekombinationsbereiche 59 aus einem die Rekombination von n- und p-Ladungsträgern fördernden Material angeordnet sind. Die Struktur aus Gate-Elektrode 60 und umgebender Isolationsschicht 70 erstreckt sich nach unten bis an eine n-dotierte Zone 54, die zusammen mit einer daran anschließenden stark n-dotierten Zone 56 eine zweite Leitungszone (Drain-Zone) des dargestellten MOSFET bildet.

Neben einem Rekombinationsbereich 19, der vollständig von der p-leitenden Kanalzone 58 umgeben ist, zeigt Figur 7 einem Rekombinationsbereich 59', der durch eine Isolationsschicht 90 gegenüber der Source-Elektrode 80, S und der Source-Zone 52 isoliert ist. Dies resultiert aus einem möglichen Herstellungsverfahren der Rekombinationszone 59' in der Sperrzone. Dabei werden vor dem Abscheiden der Source-Elektrode 80 Löcher, beispielsweise durch Ätzen, in die Sperrzone 58 eingebracht und anschließend bis auf eine Höhe unterhalb der Source-Zone 52 mit einem die Rekombination fördernden Material aufgefüllt. Anschließend wird die Isolationsschicht 90 in dem Loch über dem die Rekombination fördernden Material aufgebracht.

Wie insbesondere aus der Draufsicht in Figur 8 deutlich wird, weist das Halbleiterschaltelement gemäß Figur 7 eine gitterförmige Gate-Elektrode 60 auf, wobei in Zwischenräumen des Gitters die durch eine Isolationsschicht 70 gegenüber der Gate-Elektrode 60 isolierte Kanalzone 58 mit der Rekombinationszone 59 angeordnet ist. Das Halbleiterschaltelement weist damit eine Vielzahl gleichartig aufgebauter Zellen, die gleichzeitig angesteuert werden auf, wobei die Stromfestigkeit des Halbleiterschaltelements mit der Anzahl der Zellen steigt. Bei Anlegen eines positiven Ansteuerpotentials an die Gate-Elektrode 60 bildet sich der Kanalzone in vertikaler Richtung des Halbleiterkörpers 105 entlang der Gate-Elektrode 60 ein leitender Kanal aus, wobei bei Anlegen einer Flussspannung zwischen der Drain-Elektrode D und der Source-Elektrode S ein Stromfluss zwischen der Drain-Elektrode D und der Source-Elektrode S ermöglicht ist.

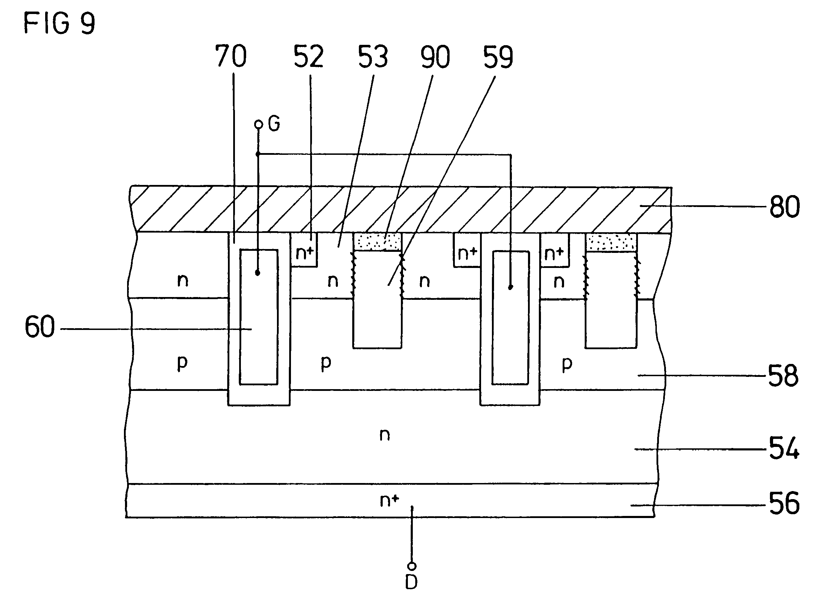

Figur 9 zeigt ausschnittsweise im Querschnitt ein weiteres Halbleiterschaltelement zur Erläuterung der vorliegenden Erfindung mit einer grabenförmigen Struktur aus Gate-Elektrode 60 und Isolationsschicht 70. Die Source-Zone besteht bei diesem Halbleiberschaltelement aus einer benachbart zu der Gate-Elektrode 60 und der Source-Elektrode 80 angeordneten stark n-dotierten Zone 52 und aus einer die stark dotierte Zone 52 in den übrigen Bereichen umgebenden normal n-dotierten Zone 53. Der Rekombinationsbereich 59 erstreckt sich bei diesem Halbleiterschaltelement von der unterhalb der Zone 53 angeordneten p-dotierten Sperrzone 58 bis in die n-dotierte Zone 53 und ist nach oben gegenüber der Source-Elektrode 80 durch eine Isolationsschicht 90 isoliert. Der Rekombinationsbereich 59 besteht bei diesem Halbleiterschaltelement vorzugsweise aus einem Metall oder einem Silizid und bildet mit der n-dotierten Zone 53 einen Schottky-Kontakt. Das Ersatzschaltbild des Halbleiterschaltelements nach Figur 9 entspricht dem in Figur 6 dargestellten.

Während sich bei den in den 2 bis 6 dargestellten Halbleiterschaltelementen bei Anlegen einer positiven Spannung zwischen der Gate- und Source-Elektrode G, S und Anlegen einer positiven Spannung zwischen der Drain- und Source-Elektrode D, S ein leitender Kanal in lateraler Richtung in der Sperrzone 18 ausbildet, bildet sich bei dem Halbleiterschaltelement nach den Figuren 7 und 8 ein leitender Kanal in vertikaler Richtung aus. Dieses Halbleiterschaltelement ist gegenüber den in den Figuren 2 bis 6 dargestellten Halbleiterschaltelementen platzsparender.

Ersetzt man die stark n-dotierte Zone 56 durch eine stark p-dotierte Zone funktionieren die in den Figuren 7 bis 9 dargestellten Bauelemente als IGBT.

Figur 10 zeigt ein weiteres Halbleiterschaltelement zur Erläuterung der vorliegenden Erfindung, das als MOSFET in lateraler Bauweise ausgebildet ist. Stark n-dotierte Drain- und Source-Zonen 216, 212 sind dabei in einer p-dotierten Sperrzone 218 des Halbleiterkörpers 200 angeordnet und mittels Source- und Drain-Elektroden S, G von derselben Seite des Halbleiterkörpers 200 kontaktierbar. Eine Gate-Elektrode G ist durch eine Isolationsschicht 230 isoliert auf dem Halbleiterkörper 200 angeordnet. In der Sperrzone 218 ist ein Rekombinationsbereich aus einem die Rekombination von n- und p-Ladungsträgern fördernden Material angeordnet.

Bei Anlegen eines positiven Ansteuerpotentials an die Gate-Elektrode bildet sich bei diesem Halbleiterschaltelement entlang der Oberfläche des Halbleiterkörpers ein leitender Kanal zwischen der Source-Zone 212 und der Drain-Zone 216 aus. n-Ladungsträger und p-Ladungsträger können auch bei dieser Ausführungsform an der Rekombinationszone 219 miteinander rekombinieren, wodurch verhindert wird, dass ein durch die Abfolge der n-leitenden Source-Zone 212, der p-leitenden Kanalzone 218 und der n-leitenden Drain-Zone 216 gebildeter parasitärer Bipolartransistor angesteuert wird.

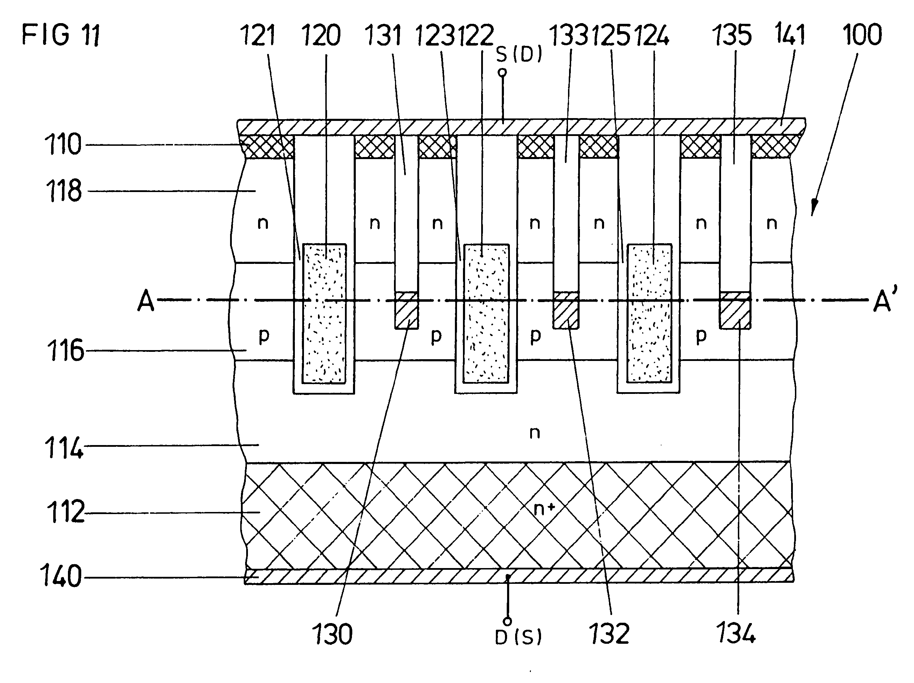

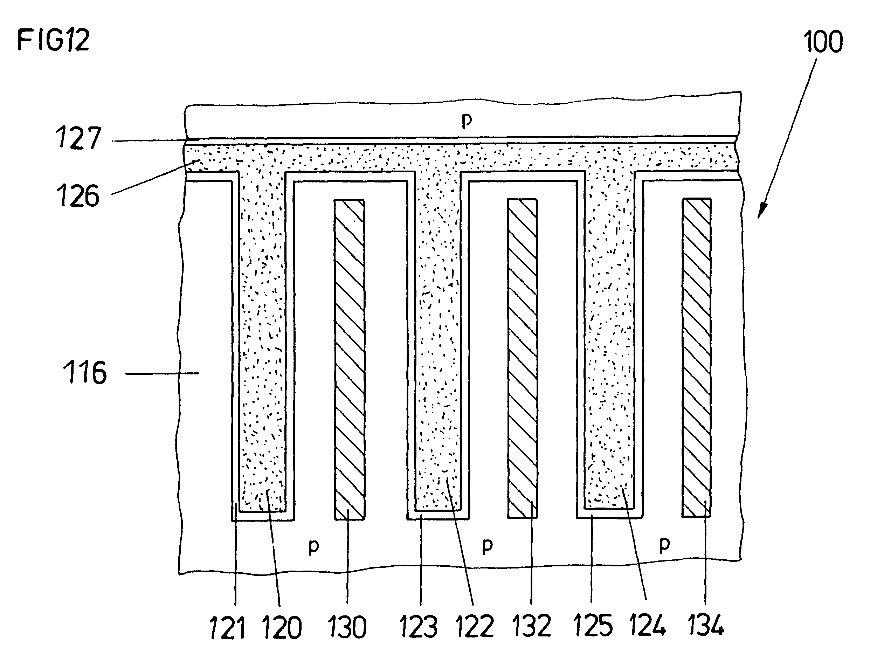

Figur 11 zeigt ein Ausführungsbeispiel eines erfindungsgemäßen in beide Richtungen sperrendes Halbleiterschaltelements in seitlicher Ansicht im Querschnitt. In Figur 12 ist ein Querschnitt durch die Anordnung nach Figur 11 entlang der Schnittebene A-A' dargestellt.

Das erfindungsgemäße Halbleiterschaltelement weist einen Halbleiterkörper 100 mit einer stark n-dotierten zweiten Anschlusszone 112 und einer benachbart zu der zweiten Anschlusszone 112 angeordneten n-dotierten zweiten Übergangzone 114, die schwächer als die zweite Anschlusszone 112 dotiert ist, auf, wobei die zweite Anschlusszone 112 und die zweite Übergangszone 114 eine zweite Leitungszone (Drain-Zone) des Halbleiterschaltelements bilden. Benachbart zu der zweiten Übergangszone 114 ist eine p-dotierte Kanalzone 116 ausgebildet, die nicht notwendigerweise homogen dotiert ist und an die sich eine n-dotierte erste Übergangszone 118 anschließt. Benachbart zu der ersten Übergangszone 118 ist eine stark n-dotierte erste Anschlusszone 110 ausgebildet, die stärker als die erste Übergangszone 118 dotiert ist, ausgebildet, wobei die erste Anschlusszone 110 und die erste Übergangszone 118 eine erste Leitungszone (Source-Zone) des Halbleiterschaltelements bilden. Die zweite Anschlusszone 112, die zweite Übergangszone 114, die Kanalzone 116, die erste Übergangszone 118 und die erste Anschlusszone 110 sind in dem Ausführungsbeispiel schichtartig übereinander angeordnet, wobei eine zweite Anschlusselektrode 140, vorzugsweise aus Metall oder Polysilizium, auf eine Rückseite des Halbleiterkörpers 100 zur Kontaktierung der zweiten Anschlusszone 112 aufgebracht ist und wobei eine erste Anschlusselektrode 141 auf eine Vorderseite des Halbleiterkörpers zur Kontaktierung der ersten Anschlusszone 110 aufgebracht ist.

Die zweite Anschlusszone 112 und die sich daran anschließende zweite Übergangszone 114 bilden die Drain-Zone des MOSFET; die erste Anschlusszone 110 und die sich daran anschließende erste Übergangszone 118 bilden die Source-Zone des MOSFET, wobei aufgrund des symmetrischen Aufbaus des in Figur 11 dargestellten FET die Drain- und Source-Anschlüsse vertauschbar sind.

Um die Ausbildung eines leitenden Kanals in der Kanalzone zwischen der Drain-Zone 112, 114 und der Source-Zone 110, 118 zu ermöglichen ist eine Steuerelektrode 120, 122, 124, 126 vorgesehen, die von einer Isolationsschicht 121, 123, 125, 127 umgeben ist und die sich in vertikaler Richtung des Halbleiterkörpers 100 von der n-dotierten ersten Übergangszone 114 durch die p-dotierte Kanalzone 116 bis in die n-dotierte zweite Übergangszone 118 erstreckt. Wie aus Figur 2 ersichtlich ist, sind in dem Ausführungsbeispiel eine Anzahl annäherungsweise paralleler Steuerelektroden 120, 122, 124 vorgesehen, die durch eine gemeinsame Platte 126 verbunden sind, wodurch die Steuerelektroden 120, 122, 124 an ein gemeinsames Ansteuerpotential gelegt werden können. Die gemeinsame Platte ist gegenüber dem Halbleiterkörper 100 durch eine Isolationsschicht 127 isoliert und erstreckt sich in vertikaler Richtung vorzugsweise bis an die Vorderseite oder Rückseite des Halbleiterkörpers 100 um an ein Ansteuerpotential angeschlossen zu werden. Vorzugsweise erstreckt sich die erste und/oder zweite Anschlusszone 110, 112 nicht bis an die gemeinsame Platte 126, um die Ausbildung eines stromführenden Kanals entlang der gemeinsamen Platte 126 zu verhindern. Selbstverständlich sind neben der gemeinsamen Platte 126 beliebige weitere Ausführungsformen denkbar, um die Steuerelektroden 120, 122, 124 an ein gemeinsames Ansteuerpotential zu legen.

Je mehr Steuerelektroden 120, 122, 124 in dem Halbleiterkörper 100 vorgesehen werden, um so größer ist die Elektrodenfläche, entlang derer sich ein stromführender Kanal ausbilden kann und um so größer ist die Stromfestigkeit des MOSFET.

Die Bereiche aus Isolationsmaterial oberhalb der Steuerelektroden 120, 122, 124 und unterhalb der Anschlusselektrode 141 entstehen durch Auffüllen der Gräben, in denen die Steuerelektroden 120, 122, 124 ausgebildet sind, mit Isolationsmaterial nach dem Herstellen der Steuerelektroden 120, 122, 124.

Erfindungsgemäß sind in der Kanalzone 116 benachbart zu den Steuerelektroden 120, 122, 124 Rekombinationszonen 130, 132, 134 vorgesehen, die die Rekombination von n- und p-Ladungsträgern in der Kanalzone 116 fördern. Die Rekombinationszonen 130, 132, 134 bestehen vorzugsweise aus einem Metall, wie zum Beispiel Platin, oder aus einem Silizid. Vorzugsweise ist der Abstand zwischen den Rekombinationszonen 130, 132, 134 und den Steuerelektroden klein und beträgt vorzugsweise weniger als 5 *µ*m.

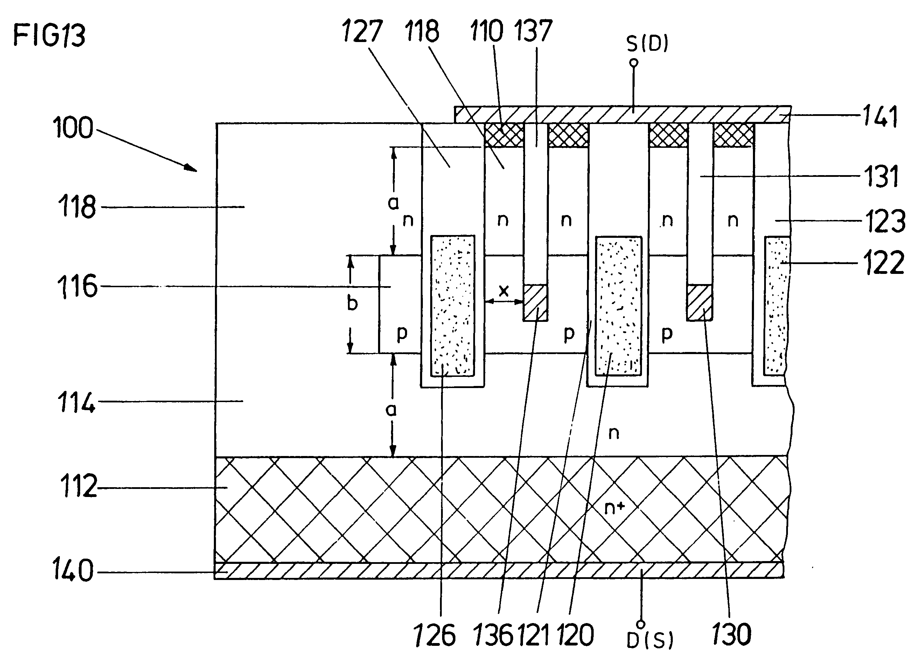

Figur 13 zeigt einen Randbereich des Halbleiterkörpers 100, in dem das erfindungsgemäße Halbleiterschaltelement ausgebildet ist. Wie aus Figur 13 ersichtlich ist, reicht die Kanalzone 116 in lateraler Richtung nicht bis an den Rand des Halbleiterkörpers 100. Weiterhin reicht die zweite Anschlusselektrode 141 in lateraler Richtung des Halbleiterkörpers 100 nur bis oberhalb einer dem Rand am nächsten liegenden Steuerelektrode 126. Die zweite Anschlusszone 110 reicht nur bis an die dem Rand abgewandte Seite des Isolationsbereichs 127 oberhalb der äußersten Steuerelektrode 126. An der dem Rand zugewandten Seitenfläche der äußersten Steuerelektrode 126 kann sich so kein leitender Kanal zwischen der ersten Anschlusszone 112 und der zweiten Anschlusszone 110 ausbilden. Die erste Übergangszone 114 und die zweite Übergangszone 118 sind im Randbereich miteinander verbunden.

Wird bei dem erfindungsgemäßen Halbleiterschaltelement eine positive Spannung zwischen der ersten Anschlusselektrode (Drain-Elektrode) 140, D und der zweiten Anschlusselektrode (Source-Elektrode) 141, S angelegt, werden in einer Raumladungszone zwischen der Drain-Zone 112, 114 und der Kanalzone Ladungsträger, nämlich Elektronen und Löcher, generiert. Die Elektronen fließen dabei aufgrund des Feldes in der Raumladungszone in die Drain-Zone 112, 114, bzw. an die Drain-Elektrode 140, die Löcher fließen in die Kanalzone 116. In der Kanalzone fördern die, vorzugsweise aus einem Metall bestehenden, Rekombinationszonen 130, 132, 134, 136 die Rekombination der in die Kanalzone injizierten Löcher mit Elektronen. Auf diese Weise wird verhindert, dass ein durch die Abfolge der n-leitenden Drain-Zone 112, 114, der p-leitenden Kanalzone 116 und der n-leitenden Source-Zone 118, 110 gebildeter parasitärer Bipolartransistor aktiv wird und die Sperrspannung des MOSFET in Drain-Source-Richtung reduziert.

Wird neben der Drain-Source-Spannung ein positives Ansteuerpotential an die Steuerelektroden 120, 122, 124, 126 angelegt, bilden sich leitende Kanäle entlang der Steuerelektroden 120, 122, 124, 126 aus und ermöglichen einen Ladungsträgeraustausch zwischen der Drain-Zone 112, 114 und der Source-Zone 110, 118.

Die Spannungsfestigkeit des MOSFET in Drain-Source-Richtung wird maßgeblich bestimmt durch die Dotierung der zweiten Übergangszone 114 und die "Dicke" der zweiten Übergangszone 114, das heißt den Abstand zwischen der stark dotierten zweiten Anschlusszone 112 und der Kanalzone 116.

Bei Anlegen einer positiven Spannung in Source-Drain-Richtung werden Ladungsträger in einem Raumladungsbereich zwischen der zweiten Übergangzone 118 und der Kanalzone 116 generiert, wobei Löcher in die Kanalzone 116 injiziert werden, wo sie an den Rekombinationszonen 130, 132, 134, 136 mit Elektronen rekombinieren und wodurch verhindert wird, dass der parasitäre Bipolartransistor aktiv wird. Die Spannungsfestigkeit des Bauelements in Source-Drain-Richtung wird maßgeblich bestimmt durch die Dotierung der ersten Übergangszone 118 und dem Abstand zwischen der stark dotierten ersten Anschlusszone 110 und der Kanalzone 116.

Das erfindungsgemäße Bauelement sperrt in beide Richtungen, das heißt sowohl in Drain-Source-Richtung als auch in Source-Drain-Richtung. Vorzugsweise sind die erste und zweite Übergangszone 114, 118 gleich dotiert und besitzen dieselbe Schichtdicke, um in Drain-Source-Richtung und in Source-Drain-Richtung dieselbe Sperrspannung zu erzielen. Im Gegensatz zu den Halbleiterschaltelementen gemäß den Figuren 1 bis 8, bei denen als Source-Zone nur eine stark n-dotierte Zone vorhanden ist, und bei denen die Sperrspannung in Drain-Source-Richtung größer als in Source-Drain-Richtung ist, lassen sich bei der Schaltungsanordnung gemäß den Figuren 11 bis 13 damit in Drain-Source-Richtung und in Source-Drain-Richtung gleiche Sperrspannungen erreichen.

Bei Herstellung des Bauelements in Silizium-Technologie und bei einer Dicke a der Kanalzone zwischen 0,5 µm und 1 µm und einer Dicke b der ersten und zweiten Übergangszone 114, 118 von etwa 5 µm lassen sich bei einer schwachen Dotierung dieser Zonen 14, 18 Sperrspannungen von etwa 50V erzielen.

Der Abstand x der Rekombinationszonen von den Steuerelektroden beträgt vorzugsweise weniger als 1 µm.

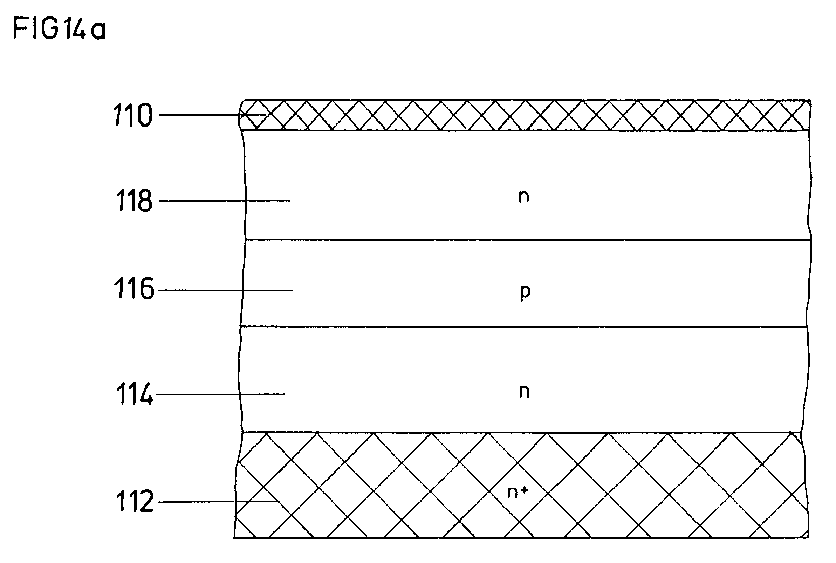

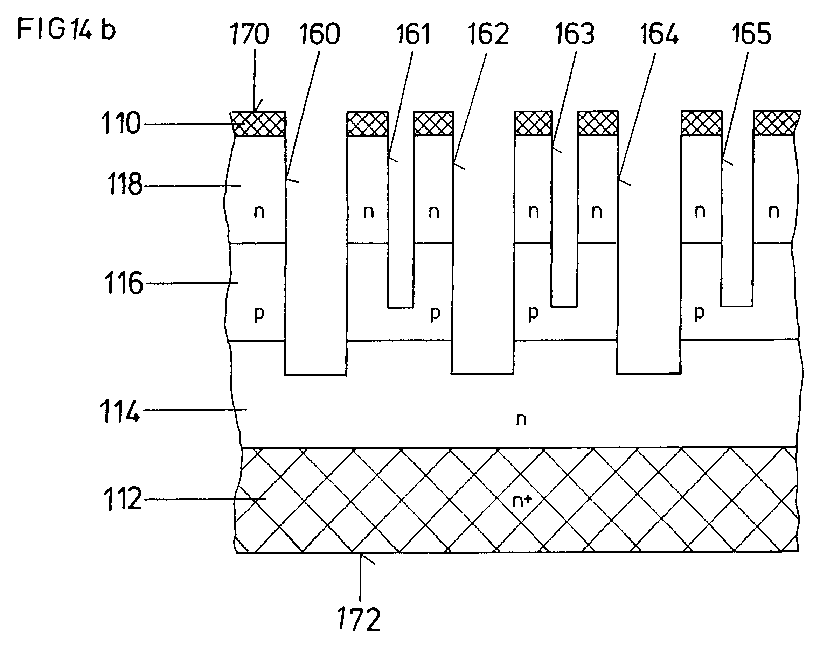

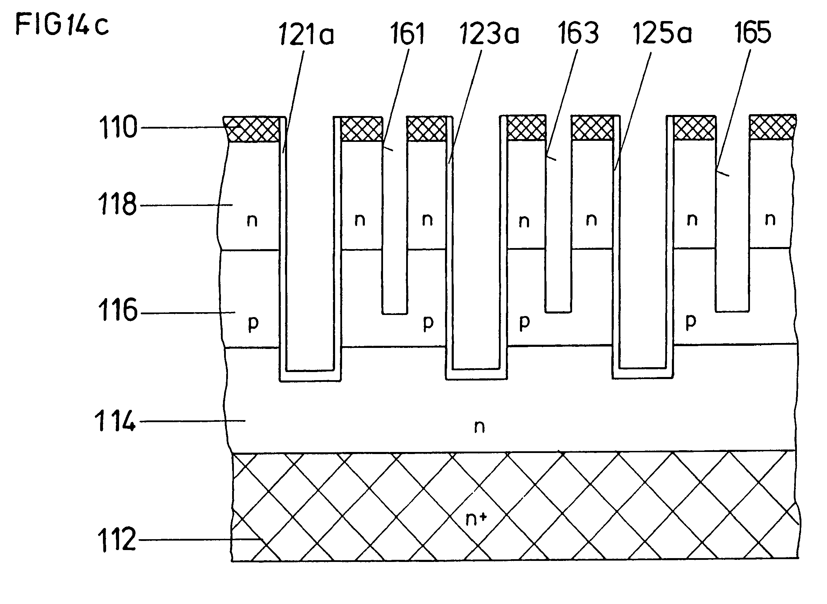

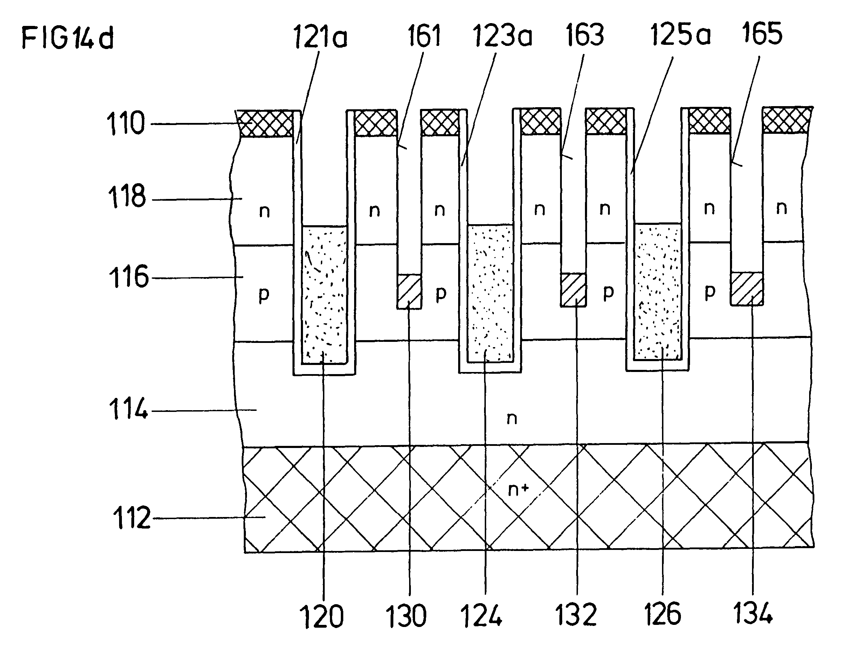

In Figur 14 ist ein Verfahren zur Herstellung eines erfindungsgemäßen Halbleiterschaltelements veranschaulicht. In ersten Verfahrensschritten (Figur 14a) wird dabei ein Halbleiterkörper 100 hergestellt, der eine stark n-dotierte zweite Anschlusszone 112 und eine benachbart zu der zweiten Anschlusszone angeordnete schwächer n-dotierte zweite Übergangszone 114 aufweist. Benachbart zu der zweiten Übergangszone 114 ist in dem Halbleiterkörper 100 eine p-dotierte Kanalzone 116 ausgebildet, an die sich eine n-dotierte erste Übergangszone 118 anschließt. Die erste Übergangszone 118 ist schwächer dotiert als eine benachbart zu der ersten Übergangszone 118 angeordnete stark n-dotierte erste Anschlusszone 110.

In einem nächsten Verfahrensschritt (Figur 14b) werden erste Gräben 160, 162, 164 erzeugt, die sich ausgehend von einer Vorderseite 170 des Halbleiterkörpers 100 bis in die zweite Übergangszone 114 erstrecken. Alternativ können die Gräben derart erzeugt werden, dass sie sich ausgehend von der Rückseite 172 des Halbleiterkörpers 100 bis in die erste Übergangszone 118 erstrecken. Außerdem werden benachbart zu den ersten Gräben 160, 162, 164 zweite Gräben 161, 163, 165 erzeugt, die sich ausgehend von der Vorderseite 170 bis in die Kanalzone 116 erstrecken. Alternativ können sich die zweiten Gräben ausgehend von der Rückseite 172 bis in die Kanalzone 116 erstrecken.

In einem nächsten Verfahrensschritt (Figur 14c) wird eine Schicht 121a, 123a, 125a aus einem Isolationsmaterial an Seitenflächen der ersten Gräben 160, 162, 164 hergestellt, um die späteren Elektroden 120, 122, 124 gegenüber dem Halbleiterkörper 100 zu isolieren.

In nächsten Verfahrensschritten wird zur Herstellung der Steuerelektroden 120, 124, 126 eine Schicht aus Elektrodenmaterial in den ersten Gräben 160, 162, 164 abgeschieden, wobei die Schicht in vertikaler Höhe des Halbleiterkörpers 100 bis in die erste Übergangszone 118 reicht. Außerdem wird in den zweiten Gräben 161, 163, 165 eine Schicht aus einem Rekombinationsmaterial abgeschieden, die sich in vertikaler Höhe des Halbleiterkörpers bis unterhalb der Grenze zu der zweiten Übergangszone 118 erstreckt, so dass die dadurch entstehenden Rekombinationszonen 130, 132, 114 nur von der Kanalzone 116 umgeben sind.
In nächsten Verfahrensschritten werden die ersten und zweiten Gräben mit einem Isolationsmaterial aufgefüllt, bevor die Anschlusselektroden 140, 141 auf die Vorder- und Rückseite 170, 172 des Halbleiterkörpers aufgebracht wird, um zu der Anordnung nach Figur 11 zu gelangen.

### Bezugszeichenliste

- 10: Halbleiterkörper
- 100: Halbleiterkörper
- 105: Halbleiterkörper
- 110: zweite Anschlusszone
- 112: erste Anschlusszone
- 114: erste Übergangszone
- 116: Kanalzone
- 118: zweite Übergangszone
- 12: erste Leitungszone
- 120, 122, 124, 126: Steuerelektroden
- 121, 123, 125, 127: Isolationsschicht
- 126: gemeinsame Platte
- 127: Isolationsschicht
- 130, 132, 134, 136: Rekombinationszone
- 14, 16: zweite Leitungszone
- 140: erste Anschlusselektrode
- 141: zweite Anschlusselektrode
- 160, 162, 164: erste Gräben
- 161, 163, 165: zweite Gräben
- 170: Vorderseite des Halbleiterkörpers
- 172: Rückseite des Halbleiterkörpers
- 18: Sperrzone
- 181: stark n-dotierte Brückenbereiche
- 19: Rekombinationsbereich
- 200: Halbleiterkörper
- 216: zweite Leitungszone
- 218: Sperrzone
- 219: Rekombinationsbereich
- 230: Isolationsschicht
- 30: Isolationsschicht
- 40: Source-Elektrode
- 52: erste Leitungszone
- 54, 56: zweite Leitungszone
- 58: Sperrzone
- 59, 59': Rekombinationsbereich
- 70: Isolationsschicht
- 80: Source-Elektrode
- 90: Isolationsschicht
- B: Basis
- B1: Bipolartransistor
- C: Kollektor
- D: Drain-Anschluß, Drain-Elektrode
- D2: Diode
- D_{CB}, D_{S}: Diode
- E: Emitter
- G: Gate-Anschluß, Gate-Elektrode
- S: Source-Anschluß, Source-Elektrode
- T1: MOSFET

## Patentansprüche

1. Ein in beide Richtungen sperrendes steuerbares Halbleiterschaltelement, das folgende Merkmale aufweist:
- eine erste Leitungszone (110, 118) und eine zweite Leitungszone (112, 114) eines ersten Leitungstyps (n,n+);
- eine zwischen der ersten und zweiten Leitungszone ( 110, 118, 112, 114) angeordnete Kanalzone (116) eines zweiten Leitungstyps (p);
- wenigstens einen in der Kanalzone (116) ausgebildeten Rekombinationsbereich (130, 132, 134) aus einem eine Rekombination von Ladungsträgern des ersten und zweiten Leitungstyps (n, p) fördernden Material,
- eine isoliert gegenüber der Kanalzone (116) angeordnete Steuerelektrode (120, 122, 124), die sich wenigstens von der ersten Übergangszone (118) durch die Kanalzone (116) bis zu der zweiten Übergangszone (114) erstreckt; bei dem:
- die zweite Leitungszone eine stärker dotierte zweite Anschlusszone (112) zum Anschließen an eine Anschlusselektrode (140) und eine schwächer dotierte zweite Übergangszone (114) benachbart zu der Kanalzone (116) aufweist; und bei dem :
- die erste Leitungszone eine stärker dotierte erste Anschlusszone (110) zum Anschließen an eine Anschlusselektrode (141) und eine schwächer dotierte erste Übergangszone (118) benachbart zu der Kanalzone (116) aufweist.

2. Halbleiterschaltelement nach Anspruch 1,
**dadurch gekennzeichnet, dass**
das Material des Rekombinationsbereichs (130, 132, 134) ein Metall ist.

3. Halbleiterschaltelement nach Anspruch 1,
**dadurch gekennzeichnet, dass**
das Material des Rekombinationsbereichs (130, 132, 134) ein Silizid oder Polysilizium ist.

4. Halbleiterschaltelement nach einem der vorangehenden Ansprüche,
**dadurch gekennzeichnet, dass**
mehrere Rekombinationsbereiche (130,132,134) in der Kanalzone (116) ausgebildet sind.

5. Halbleiterschaltelement nach Anspruch 4,
**dadurch gekennzeichnet, dass**
die Rekombinationsbereiche (130, 132, 134) im wesentlichen streifenförmig ausgebildet und im wesentlichen parallel zueinander angeordnet sind.

6. Halbleiterschaltelement nach einem der vorangehenden Ansprüche
**dadurch gekennzeichnet, dass**
die erste Leitungszone (110, 118), die Kanalzone (116) und die zweite Leitungszone (12, 114) schichtartig übereinander angeordnet sind.

7. Halbleiterschaltelement nach Anspruch 6,
**dadurch gekennzeichnet, dass**
die erste und zweite Übergangszone (114, 118) der ersten und zweiten Leitungszone (110, 118, 112, 114) dieselbe Schichtdicke aufweisen.

8. Halbleiterschaltelement nach einem der vorangehenden Anspruche,
**dadurch gekennzeichnet, dass**
die erste und zweite Übergangszone (114, 118) wenigstens annäherungsweise dieselbe Dotierungskonzentration aufweisen.

9. Halbleiterschaltelement nach einem der vorangehenden Ansprüche,
**dadurch gekennzeichnet, dass**
der Abstand der wenigstens einen Rekombinationszone (130,132, 134) von der wenigstens einen Steuerelektrode (120, 122, 124, 126) klein ist und vorzugsweise weniger als 1 µm beträgt.

10. Verfahren zur Herstellung eines in beide Richtungen sperrenden steuerbaren Halbleiterschaltelements, das folgende Merkmale aufweist:
- Bereitstellen eines Halbleiterkörpers mit einer zweiten Anschlusszone (112) eines ersten Leitungstyps (n), einer benachbart zu der zweite Anschlusszone (112) angeordneten schwächer als die zweite Anschlusszone (112) dotierten zweiten Übergangszone (114) des ersten Leitungstyps (n), einer benachbart zu der zweiten Übergangszone (114) angeordneten Kanalzone (116) eines zweiten Leitungstyps (p), einer benachbart zu der Kanalzone (116) angeordneten ersten Übergangszone (118) des ersten Leitungstyps (n), einer benachbart zu der ersten Übergangszone (118) angeordneten, stärker als die zweite Übergangszone (118) dotierten ersten Anschlusszone (110) des ersten Leitungstyps (n);
- Herstellen wenigstens einer von einer Isolationsschicht (121, 123, 125, 127) umgebenen Steuerelektrode (120, 122, 124, 126), die sich wenigstens von der ersten Übergangszone (118) durch die Kanalzone (116) bis zu der zweiten Übergangszone (114) erstreckt;
- Herstellen wenigstens einer in der Kanalzone (116) angeordneten Rekombinationszone (130, 132, 134) aus einem die Rekombination von Ladungsträgern des ersten und zweiten Leitungstyps (n, p) fördernden Materials.

11. Verfahren nach Anspruch 10, bei dem die zweite Anschlusszone (112), die zweite Übergangszone (114), die Kanalzone (116), die erste Übergangszone (118) und die erste Anschlusszone (110) schichtartig übereinander angeordnet werden.

12. Verfahren nach Anspruch 11, bei dem die Herstellung der wenigstens einen Steuerelektrode (120, 124, 126, 128) folgende Verfahrensschritte umfasst:
- Erzeugen wenigstens eines ersten Grabens (160, 162, 164) in dem Halbleiterkörper (100), der sich ausgehend von einer Seite des Halbleiterkörpers (100) bis in die dieser Seite abgewandte Übergangszone (114; 118) erstreckt;
- Abscheiden einer Isolationsschicht (121, 123, 125, 127) in dem sich bis in eine Übergangszone (114 ; 118) erstreckenden Graben (161, 163, 165);
- Abscheiden von Elektrodenmaterial in dem sich bis in eine Übergangszone (114 ; 118) erstreckenden Graben zur Herstellung der Steuerelektrode (120, 122, 124, 126);
- Auffüllen des sich bis in eine Übergangszone (114 ; 118) erstreckenden Grabens (160, 162, 164) mit einem Isolationsmaterial.

13. Verfahren nach Anspruch 11 oder 12, bei dem die Herstellung der wenigstens einen Rekombinationszone (130, 132, 134) folgende Verfahrensschritte umfasst:
- Erzeugen wenigstens eines weiteren Grabens (161, 163, 165) der sich ausgehend von einer Seite des Halbleiterkörpers, bis in die Kanalzone (116) erstreckt;
- Abscheiden eines die Rekombination von Ladungsträgern des ersten und zweiten Leitungstyps (n, p) fördernden Materials in dem sich bis in die Kanalzone (116) erstreckenden Graben (161, 163, 165) in der Kanalzone (116);
- Auffüllen des sich bis in die Kanalzone (116) erstreckenden Grabens (161, 163, 165) mit einem Isolationsmaterial.

14. Verfahren nach Anspruch 13, bei dem der Abstand der sich bis in eine Übergangszone (114;118) erstreckenden und sich bis in die Kanalzone (116) erstreckenden Gräben (160, 162, 164, 161, 163, 165) sehr klein ist und vorzugsweise weniger als 1 µm beträgt.

15. Verfahren nach einem der Ansprüche 10 bis 14, bei dem eine Vielzahl von benachbarten sich bis in eine Übergangszone (114;118) erstreckenden und sich bis in die Kanalzone (116) erstreckenden Gräben (160, 162, 164, 161, 163, 165) hergestellt werden, in denen jeweils Steuerelektroden (120, 122, 124, 126), bzw. Rekombinationszonen (130, 132, 134), hergestellt werden.

16. Verfahren nach einem der Ansprüche 10 bis 15, bei dem die erste und zweite Übergangszone (114, 118) wenigstens annäherungsweise dieselbe Dotierungskonzentration aufweisen.

17. Verfahren nach einem der Ansprüche 10 bis 16, bei dem die erste und zweite Übergangszone (114, 118) wenigstens annäherungsweise dieselbe Schichtdicke aufweisen.

## Claims

1. Controllable semiconductor switching element that blocks in both directions, having the following features:
- a first conduction zone (110, 118) and a second conduction zone (112, 114) of a first conduction type (n, n+) ;
- a channel zone (116) of a second conduction type (p) arranged between the first and second conduction zones (110, 118, 112, 114);
- at least one recombination region (130, 132, 134) which is formed in the channel zone (116) and is made of a material which promotes a recombination of charge carriers of the first and second conduction types (n, p),
- a control electrode (120, 122, 124) arranged in a manner insulated from the channel zone (116), which electrode extends at least from the first transition zone (118) through the channel zone (116) as far as the second transition zone (114); in which:
- the second conduction zone has a more heavily doped second terminal zone (112) for connection to a terminal electrode (140) and a more weakly doped second transition zone (114) adjacent to the channel zone (116); and in which:
- the first conduction zone has a more heavily doped first terminal zone (110) for connection to a terminal electrode (141) and a more weakly doped first transition zone (118) adjacent to the channel zone (116).

2. Semiconductor switching element according to Claim 1,
**characterized in that**
the material of the recombination region (130, 132, 134) is a metal.

3. Semiconductor switching element according to Claim 1,
**characterized in that**
the material of the recombination region (130, 132, 134) is a silicide or polysilicon.

4. Semiconductor switching element according to one of the preceding claims,
**characterized in that**
a plurality of recombination regions (130, 132, 134) are formed in the channel zone (116).

5. Semiconductor switching element according to Claim 4,
**characterized in that**
the recombination regions (130, 132, 134) are formed essentially in a strip-type manner and are arranged essentially parallel to one another.

6. Semiconductor switching element according to one of the preceding claims,
**characterized in that**
the first conduction zone (110, 118), the channel zone (116) and the second conduction zone (12, 114) are arranged in a layer-like manner one above the other.

7. Semiconductor switching element according to Claim 6,
**characterized in that**
the first and second transition zones (114, 118) of the first and second conduction zones (110, 118, 112, 114) have the same layer thickness.

8. Semiconductor switching element according to one of the preceding claims,
**characterized in that**
the first and second transition zones (114, 118) have at least approximately the same doping concentration.

9. Semiconductor switching element according to one of the preceding claims,
**characterized in that**
the distance between the at least one recombination zone (130, 132, 134) and the at least one control electrode (120, 122, 124, 126) is small and is preferably less than 1 *µ*m.

10. Method for fabricating a controllable semiconductor switching element that blocks in both directions, having the following features:
- provision of a semiconductor body having a second terminal zone (112) of a first conduction type (n), a second transition zone (114) of the first conduction type (n), which is arranged adjacent to the second terminal (112) and is doped more weakly than the second terminal zone (112), a channel zone (116) of a second conduction type (p), which is arranged adjacent to the second transition zone (114), a first transition zone (118) of the first conduction type (n), which is arranged adjacent to the channel zone (116), a first terminal zone (110) of the first conduction type (n), which is arranged adjacent to the first transition zone (118) and is doped more heavily than the second transition zone (118) ;
- fabrication of at least one control electrode (120, 122, 124, 126) which is surrounded by an insulation layer (121, 123, 125, 127) and extends at least from the first transition zone (118) through the channel zone (116) as far as the second transition zone (114);
- fabrication of at least one recombination zone (130, 132, 134) which is arranged in the channel zone (116) and is made of a material which promotes the recombination of charge carriers of the first and second conduction types (n, p).

11. Method according to Claim 10, in which the second terminal zone (112), the second transition zone (114), the channel zone (116), the first transition zone (118) and the first terminal zone (110) are arranged in a layer-like manner one above the other.

12. Method according to Claim 11, in which the fabrication of the at least one control electrode (120, 124, 126, 128) comprises the following method steps:
- production of at least one first trench (160, 162, 164) in the semiconductor body (100), which, proceeding from one side of the semiconductor body (100), extends right into the transition zone (114; 118) remote from said side;
- deposition of an insulation layer (121, 123, 125, 127), in the trench (161, 163, 165) which extends right into a transition zone (114; 118);
- deposition of electrode material in the trench which extends right into a transition zone (114; 118) for the purpose of fabricating the control electrode (120, 122, 124, 126);
- filling of the trench (160, 162, 164) which extends right into a transition zone (114; 118) with an insulation material.

13. Method according to Claim 11 or 12, in which the fabrication of the at least one recombination zone (130, 132, 134) comprises the following method steps:
- production of at least one further trench (161, 163, 165) which, proceeding from one side of the semiconductor body, extends right into the channel zone (116) ;
- deposition of a material which promotes the recombination of charge carriers of the first and second conduction types (n, p) in the trench (161, 163, 165) which extends right into the channel zone (116) in the channel zone (116);
- filling of the trench (161, 163, 165) which extends right into the channel zone (116) with an insulation material.

14. Method according to Claim 13, in which the distance between the trenches (160, 162, 164, 161, 163, 165) which extend right into a transition zone (114; 118) and which extend right into the channel zone (116) is very small and is preferably less than 1 *µ*m.

15. Method according to one of Claims 10 to 14, in which a multiplicity of adjacent trenches (160, 162, 164, 161, 163, 165) which extend right into a transition zone (114; 118) and which extend right into the channel zone (116) are fabricated in which respective control electrodes (120, 122, 124, 126) or recombination zones (130, 132, 134) are fabricated.

16. Method according to one of Claims 10 to 15, in which the first and second transition zones (114, 118) have at least approximately the same doping concentration.

17. Method according to one of Claims 10 to 16, in which the first and second transition zones (114, 118) have at least approximately the same layer thickness.

## Revendications

1. Elément de commutation à semiconducteur, pouvant être commandé, à blocage dans les deux sens et ayant les caractéristiques suivantes :
- une première zone (110, 118) de conductivité et une deuxième zone (112, 114) de conductivité d'un premier type (n, n+) de conductivité ;
- une zone (116) de canal, disposée entre la première et la deuxième zone (110, 118, 112, 114) de conductivité et d'un deuxième type (p) de conductivité ;
- au moins une zone (130, 132, 134) de recombinaison, formée dans la zone (116) de canal et en un matériau favorisant une recombinaison des porteurs de charge du premier et du deuxième type (n, p) de conductivité ;
- une électrode (120, 122, 124) de commande, disposée de façon isolée par rapport à la zone (116) de canal et s'étendant au moins de la première zone (118) de jonction jusqu'à la deuxième zone (114) de jonction en passant par la zone (116) de canal ;
dans lequel :
- la deuxième zone de conductivité a une deuxième zone (112) de borne dopée fortement pour la connexion à une électrode (140) formant borne et une deuxième zone (114) de jonction dopée faiblement et voisine de la zone (116) de canal; et
dans lequel :
- la première zone de conductivité a une première zone (110) de borne dopée fortement pour la connexion à une électrode (141) formant borne et une première zone (118) de jonction dopée faiblement et voisine de la zone (116) de canal.

2. Elément de commutation à semiconducteur suivant la revendication 1, **caractérisé en ce que** le matériau de la région (130, 132, 134) de recombinaison est un métal.

3. Elément de commutation à semiconducteur suivant la revendication 1, **caractérisé en ce que** le matériau de la région (130, 132, 134) de recombinaison est un siliciure ou du polysilicium.

4. Elément de commutation à semiconducteur suivant l'une des revendications précédentes, **caractérisé en ce que** plusieurs régions (130, 132, 134) de recombinaison sont formées dans la zone (116) de canal.

5. Elément de commutation à semiconducteur suivant la revendication 4, **caractérisé en ce que** les régions (130, 132, 134) de recombinaison sont sensiblement en forme de bande et sont disposées en étant sensiblement parallèles entre elles.

6. Elément de commutation à semiconducteur suivant l'une des revendications précédentes, **caractérisé en ce que** la première zone (110, 118) de conductivité, la zone (116) de canal et la deuxième zone (112, 114) de conductivité sont disposées les unes au-dessus des autres à la manière de couches.

7. Elément de commutation à semiconducteur suivant la revendication 6, **caractérisé en ce que** la première et la deuxième zone (114, 118) de jonction des première et deuxième zones (110, 118, 112, 114) de conductivité ont la même épaisseur de couche.

8. Elément de commutation à semiconducteur suivant l'une des revendications précédentes, **caractérisé en ce que** la première et la deuxième zone (114, 118) de jonction ont au moins à peu près la même concentration de dopage.

9. Elément de commutation à semiconducteur suivant l'une des revendications précédentes, **caractérisé en ce que** la distance entre la au moins une zone (130, 132, 134) de recombinaison et la au moins une électrode (120, 122, 124, 126) de commande est petite et de préférence inférieure à 1 µm.

10. Procédé de production d'un élément de commutation à semiconducteur pouvant être commandé et à blocage dans les deux sens, qui a les caractéristiques suivantes :
- on se procure un corps semiconducteur ayant une deuxième zone (112) de borne d'un premier type (n) de conductivité, une deuxième zone (114) de jonction du premier type (n) de conductivité, disposée au voisinage de la deuxième zone (112) de borne et dopée moins que la deuxième zone (112) de borne, une zone (116) de canal d'un deuxième type (p) de conductivité et disposée au voisinage de la deuxième zone (114) de jonction, une première zone (118) du premier type (n) de conductivité et disposée au voisinage de la zone (116) de canal, une première zone (110) de borne du premier type (n) de conductivité, disposée au voisinage de la première zone (118) de jonction et plus dopée que la deuxième zone (118) de jonction ;
- on produit au moins une électrode (120, 122, 124, 126) de commande, entourée d'une couche (121, 123, 125, 127) isolante et s'étendant au moins de la première zone (118) de jonction à la deuxième zone (114) de jonction en passant par la zone (116) de canal ;
- on produit au moins une zone (130, 132, 134) de recombinaison, disposée dans la zone (116) de canal et en un matériau favorisant la recombinaison de porteurs de charge du premier et deuxième types (n, p) de conductivité.

11. Procédé suivant la revendication 10, dans lequel on dispose les unes au-dessus des autres, à la manière de couches, la deuxième zone (112) de borne, la deuxième zone (114) de jonction, la zone (116) de canal, la première zone (118) de jonction et la première zone (110) de borne.

12. Procédé suivant la revendication 1, dans lequel la production d'au moins une électrode (120, 124, 126, 128) de commande comprend les stades de procédé suivants :
- on produit au moins un premier sillon (160, 162, 164) dans le corps (110) semiconducteur, qui s'étend d'une face du corps (110) semiconducteur jusqu'à la zone (114, 118) de jonction éloignée de cette face ;
- on dépose une couche (121, 123, 125, 127) isolante dans le sillon (161, 163, 165) s'étendant jusque dans une zone (114, 118) de jonction ;
- on dépose du matériau d'électrode dans le sillon s'étendant jusque dans une zone (114, 118) de jonction pour la production de l'électrode (120, 122, 124, 126) de commande ;
- on remplit le sillon (160, 162, 164) s'étendant jusque dans une zone (114, 118) de jonction d'un matériau isolant.

13. Procédé suivant la revendication 11 ou 12, dans lequel la production de la au moins une zone (130, 132, 134) de recombinaison comprend des stades de procédé suivants :
- on produit au moins un autre sillon (161, 163, 165) qui s'étend d'une face du corps semiconducteur à la zone (116) de canal ;
- on dépose un matériau favorisant la recombinaison de porteurs de charge du premier et du deuxième types (n, p) de conductivité dans le sillon (161, 163, 165) de la zone (116) de canal s'étendant jusque dans la zone (116) de canal ;
- on remplit le sillon (161, 163, 165) s'étendant jusqu'à la zone (116) de canal d'un matériau isolant.

14. Procédé suivant la revendication 13, dans lequel la distance entre les sillons (160, 162, 164, 161, 163, 165) s'étendant jusqu'à une zone (114, 118) de jonction et s'étendant jusqu'à la zone (116) de canal est très petite et de préférence est plus petite que 1 µm.

15. Procédé suivant l'une des revendications 10 à 14, dans lequel on produit une pluralité de sillons (160, 162, 164, 161, 163, 165) voisins s'étendant jusqu'à une zone (114, 118) de jonction et s'étendant jusqu'à la zone (116) de canal, dans lesquels on produit respectivement des électrodes (120, 122, 124, 126) de commande et des zones (130, 132, 134) de recombinaison.

16. Procédé suivant l'une des revendications 10 à 15, dans lequel les première et deuxième zones (114, 118) de jonction ont au moins à peu près la même concentration de dopage.

17. Procédé suivant l'une des revendications 10 à 16, dans lequel la première et la deuxième zones (114, 118) de jonction ont au moins à peu près la même épaisseur de couche.
